# EUROPÄISCHE PATENTSCHRIFT

(11) **EP 3 161 864 B1**
(45) Veröffentlichungstag und Bekanntmachung des Hinweises auf die Patenterteilung: **22.01.2020**
(21) Anmeldenummer: 15729157.6
(22) Anmeldetag: 15.06.2015
(51) Int. Cl.: H01L 23/495, H01L 21/48

(54) **BANDFÖRMIGES SUBSTRAT ZUR HERSTELLUNG VON CHIPTRÄGERN, ELEKTRONISCHES MODUL MIT EINEM SOLCHEN CHIPTRÄGER, ELEKTRONISCHE EINRICHTUNG MIT EINEM SOLCHEN MODUL UND VERFAHREN ZUR HERSTELLUNG EINES SUBSTRATES**
STRIP-SHAPED SUBSTRATE FOR PRODUCING CHIP CARRIERS, ELECTRONIC MODULE WITH A CHIP CARRIER OF THIS TYPE, ELECTRONIC DEVICE WITH A MODULE OF THIS TYPE, AND METHOD FOR PRODUCING A SUBSTRATE
SUBSTRAT EN FORME DE BANDE SERVANT À PRODUIRE DES SUPPORTS DE PUCE, MODULE ÉLECTRONIQUE COMPRENANT UN SUPPORT DE PUCE DE CE TYPE, DISPOSITIF ÉLECTRONIQUE COMPRENANT UN MODULE DE CE TYPE ET PROCÉDÉ DE PRODUCTION D'UN SUBSTRAT

(30) Priorität: 25.06.2014 DE 102014108916
(43) Veröffentlichungstag der Anmeldung: 03.05.2017
(73) Patentinhaber: Heraeus Deutschland GmbH & Co. KG, 63450 Hanau (DE)
(72) Erfinder: DITZEL, Eckhard, 63859 Linsengericht (DE); WALTER, Siegfried, 63571 Gelnhausen (DE); BENEDIKT, Michael, 63543 Neuberg (DE); BECKER, Udo, 36396 Steinau (DE)
(74) Vertreter: Meissner Bolte Partnerschaft mbB
(86) Internationale Anmeldenummer: PCT/EP2015/063257
(87) Internationale Veröffentlichungsnummer: WO 2015/197386

(56) Entgegenhaltungen:
- EP-A1- 1 557 881
- EP-A2- 0 712 160
- DE-U1-202012 100 694
- JP-A- H0 661 408
- JP-A- S61 284 949
- US-A- 4 805 009
- US-A- 5 252 783
- US-A- 5 792 286
- US-A1- 2002 163 015
- US-A1- 2006 054 912

## Beschreibung

Die Erfindung bezieht sich auf ein bandförmiges Substrat aus einer Folie mit mehreren Einheiten zur Herstellung von Chipträgern sowie auf ein elektronisches Modul mit einem solchen Chipträger, eine elektronische Einrichtung mit einem solchen Modul und ein Verfahren zur Herstellung eines Substrates. Ein Substrat mit den Merkmalen des Oberbegriffs des Anspruchs 1 ist beispielsweise aus DE 20 2012 100 694 U1 und US 2006/0054912 A1 bekannt, die auf die Anmelderin zurückgeht.

Die aus dem bandförmigen Substrat hergestellten Chipträger werden für elektronische Module, wie beispielsweise RFID-Chips (Radio-Frequency Identification), verwendet, die in Chipkarten zum Einsatz kommen. RFID-Chipkarten verfügen über Speicherchips, die mit Hilfe einer externen RFID-Antenne mit Funkerkennung und Transponder zur Energieversorgung kontaktlos gelesen und beschrieben werden können. Mögliche Einsatzgebiete solcher RFID-Chips sind Ausweise mit biometrischen Daten (Personalausweis, Reisepass), Gesundheitskarten, Bankkarten oder Fahrkarten für den öffentlichen Verkehr.

Zur Herstellung derartiger RFID-Chips wird das eingangs genannte bandförmige Substrat mit einer Vielzahl von Halbleiterchips bestückt, die jeweils mit einer Vergussmasse oder Moldmasse eingekapselt werden. Dazu weist das eingangs genannte bandförmige Substrat eine Folie mit mehreren Einheiten zur Herstellung von Chipträgern auf, wobei jeweils eine Einheit eine Chipinsel zur Befestigung des Halbleiterchips, Elektroden zur elektrischen Verbindung des Halbleiterchips und Durchbrüche zur Strukturierung der Einheit aufweist. Die so gebildeten Module werden nach einer Funktionsprüfung aus dem Band vereinzelt und in die Chipkarte integriert.

Da die Chipkarten flach sind, dürfen die Module einerseits eine maximale Gesamtdicke nicht überschreiten. Andererseits müssen die Module eine ausreichende Stabilität aufweisen, um zu verhindern, dass es zu einer Beschädigung des Chips oder des Chipträgers kommt, wodurch die Funktion der Chipkarte beeinträchtigt werden kann.

Für eine einwandfreie Funktion der Chipkarte ist ferner eine gute Verankerung der Vergussmasse, die den Chip einkapselt, erforderlich. Dazu bilden die im Substrat vorgesehenen Durchbrüche Verankerungskanten für die Vergussmasse zur Einkapselung des Halbleiterchips.

Die Verankerungskante ist bei dem aus DE 20 2012 100 694 U1 bekannten Substrat durch eine Abstufung gebildet, die als Hinterschneidung dient. Die Hinterschneidung bzw. Abstufung wird durch Prägen der Unterseite des Substrats hergestellt. Die Hinterschneidung wird beim Einkapseln des Chips mit der Vergussmasse ausgefüllt, wodurch der gewünschte Verankerungseffekt erreicht wird. Für einen ausreichenden Effekt ist eine Mindest-Folienstärke erforderlich, damit die Hinterschneidung eine ausreichende Tiefe aufweist, die einen entsprechenden Freiraum für die Aufnahme der Vergussmasse bildet. Die Mindest-Folienstärke begrenzt die minimale Gesamtdicke des elektrischen Moduls, die mit dem bekannten Substrat praktisch nicht unterschritten werden kann, ohne eine zuverlässige Funktionsweise des Chipträgers zu beeinträchtigen.

Der Erfindung liegt die Aufgabe zu Grunde, ein bandförmiges Substrat zur Herstellung von Chipträgern anzugeben, das eine Verringerung der Gesamtdicke der aus den Chipträgern hergestellten elektrischen Module ermöglicht. Der Erfindung liegt ferner die Aufgabe zu Grunde, ein elektronisches Modul mit einem Chipträger, eine elektronische Einrichtung, insbesondere eine Chipkarte, mit einem solchen Modul sowie ein Verfahren zur Herstellung eines Substrates anzugeben.

Erfindungsgemäß wird diese Aufgabe mit Blick auf das bandförmige Substrat durch den Gegenstand des Anspruchs 1, mit Blick auf das elektronische Modul durch den Gegenstand des Anspruchs 6, mit Blick auf die elektronische Einrichtung durch den Gegenstand des Anspruchs 7 und mit Blick auf das Verfahren zur Herstellung des Substrates durch den Gegenstand des Anspruchs 8 gelöst.

Die Erfindung beruht auf dem Gedanken, ein bandförmiges Substrat aus einer Folie mit mehreren Einheiten zur Herstellung von Chipträgern anzugeben. Jeweils eine Einheit weist eine Chipinsel zur Befestigung eines Halbleiterchips, Elektroden zur elektrischen Verbindung des Halbleiterchips und Durchbrüche zur Strukturierung der Einheit auf. Wenigstens ein Durchbruch bildet eine Verankerungskante für eine Vergussmasse zur Einkapselung des Halbleiterchips. Ein an den Durchbruch angrenzender Flächenabschnitt der Folie ist zur Bildung der Verankerungskante abgekantet. Die Verankerungskante steht über die Seite der Folie vor, auf der die Chipinsel angeordnet ist.

Anstelle der durch Verringerung der Materialstärke erzeugten bekannten Hinterschneidung wird erfindungsgemäß die Verankerungskante durch Biegen umgeformt, d.h. abgekantet. Dies hat den Vorteil, dass die Folienstärke nicht der limitierende Faktor für die Erzeugung des Verankerungseffektes ist. Vielmehr wird durch die Abkantung des an den Durchbruch angrenzenden Flächenabschnittes eine Profilierung der Folie erzeugt, die beim Einkapseln des Halbleiterchips die gewünschte sichere Verbindung zwischen der Mold-Kappe bzw. der Vergussmasse und dem Substrat liefert und zwar unabhängig von der Substratdicke bzw. Foliendicke.

Für die Verankerung steht die Verankerungskante über die Seite der Folie vor, auf der die Chipinsel angeordnet ist. Dadurch wird die Verankerungskante beim Einkapseln des Halbleiterchips in die Vergussmasse eingebettet, so dass eine sichere mechanische Verbindung zwischen dem Substrat und der Vergussmasse entsteht. Der abgekantete Flächenabschnitt hat den weiteren Vorteil, dass der Chipträger bzw. allgemein Bereiche des Chipträgers mechanisch stabilisiert werden.

Insgesamt ermöglicht die Erfindung eine Verringerung der Foliendicke gegenüber dem Stand der Technik, ohne dabei die sichere Verankerung der Vergussmasse mit dem Substrat sowie die Stabilität der aus dem Substrat hergestellten Chipträger zu beeinträchtigen.

Die Verankerungskante kann einfach abgekantet sein. Der abgekantete Flächenabschnitt ist dann bis auf die Biegekante flach ausgebildet. Alternativ kann die Verankerungskante profiliert sein. Beispielsweise kann der abgekantete Flächenabschnitt ein L-Profil aufweisen. Andere Profile sind möglich.

Die Dicke der Folie beträgt von 15 µm bis 35 µm. Bei einer besonders bevorzugten Ausführungsform beträgt die Foliendicke ca. 20 µm. Mit den vorgenannten Werten kann die Gesamtdicke des elektrischen Moduls, das auch als package bezeichnet werden kann, unter Verwendung der aus dem Substrat hergestellten Chipträger auf ca. 200 µm verringert werden.

Die Folie ist aus einem hartgewalzten austenitischen Edelstahl, gebildet. Im Unterschied zu den im Stand der Technik üblicherweise verwendeten Kupferlegierungen weist Stahl bei sehr hohen Festigkeiten ein noch ausreichendes Umformvermögen auf. Unter dem Begriff Edelstahl werden nach EN 10020 legierte oder unlegierte Stähle mit besonderem Reinheitsgrad, z.B. Stähle mit einem Schwefel- und Phosphorgehalt von maximal 0,025% verstanden. Das austenitische Gefüge führt zu einem rost- und säurebeständigen Stahl, bspw. nach DIN 267 Teil 11. Stahl hat den Vorteil einer hohen Festigkeit bei gutem Umformvermögen.

Bei einer bevorzugten Ausführungsform beträgt der Abkantwinkel zwischen dem abgekanteten Flächenabschnitt und der weiteren Fläche der Folie von 30° bis 60°, insbesondere von 40° bis 50°. Bei einer besonders bevorzugten Ausführungsform beträgt der Abkantwinkel ca. 45°. Der Abkantwinkel in den vorgenannten Bereichen ermöglicht eine ausreichende Einbettung der Verankerungskante in die Vergussmasse, wobei die Vergussmasse unter den abgekanteten Flächenabschnitt fließen kann und diesen vollständig umgibt.

Zweckmäßigerweise ist der abgekantete Flächenabschnitt gerade. Damit wird eine besonders gute Stabilisierung der Folie erreicht bzw. die Einleitung unerwünschter mechanischer Spannungen in die Folie vermieden. Der gerade Flächenabschnitt erstreckt sich geradlinig und parallel zur Oberfläche der Folie.

Wenigstens ein abgekanteter Flächenabschnitt kann ein kammartiges Profil zur Verringerung mechanischer Spannungen aufweisen. Zusätzlich oder alternativ kann wenigstens ein abgekanteter Flächenabschnitt eine glatte Außenkante aufweisen.

Die Durchbrüche weisen abkantungsfreie Krümmungen und/oder abkantungsfreie Ausnehmungen zur Verringerung mechanischer Spannungen auf. Dabei sind Flächenabschnitte, die an gekrümmte Bereiche der Durchbrüche angrenzen, mit der weiteren Fläche der Folie fluchtend ausgebildet, so dass sich eine abkantungsfreie Anordnung ergibt. Dadurch wird die Herstellung des Substrates vereinfacht. Mechanische Spannungen werden im Material verringert.

Zur Stabilisierung der Chipinsel weisen zumindest Durchbrüche, die an die Chipinsel angrenzen, insbesondere deren Innenseiten, Verankerungskanten auf. Damit wird nicht nur die Chipinsel mechanisch stabilisiert, sondern auch eine besonders gute Verankerung der Vergussmasse im unmittelbaren Bereich des Halbleiterchips erreicht.

Die Erfindung bezieht sich ferner auf ein elektronisches Modul mit einem Chipträger, der eine Chipinsel und einen darauf befestigten Halbleiterchip, Elektroden zur elektrischen Verbindung des Halbleiterchips, insbesondere durch Bonddrähte, und Durchbrüche zur Strukturierung des Chipträgers aufweist. Wenigstens ein Durchbruch bildet eine Verankerungskante für eine Vergussmasse, die den Halbleiterchip einkapselt. Ein an den Durchbruch angrenzender Flächenabschnitt des Chipträgers ist zur Bildung der Verankerungskante abgekantet. Die Verankerungskante steht über die Seite des Chipträgers vor, auf der die Chipinsel angeordnet ist. Die Verankerungskante ist in die Vergussmasse eingebettet. Die Durchbrüche weisen abkantungsfreie Krümmungen und/oder abkantungsfreie Ausnehmungen zur Verringerung mechanischer Spannungen auf. Die Dicke des Chipträgers ist 15 µm bis 35 µm und ist aus einem hartgewalzten austenitischen Edelstahl gebildet.

Das erfindungsgemäß ausgebildete Modul bzw. Package beruht auf demselben Gedanken, wie das erfindungsgemäße Substrat und weist einen an den Durchbruch angrenzenden, abgekanteten Flächenabschnitt zur Bildung der Verankerungskante auf, die demgemäß über die Seite des Chipträgers vorsteht, auf der die Chipinsel angeordnet ist. Bei dem Modul ist der Halbleiterchip auf die Chipinsel montiert und in der Vergussmasse eingebettet. Zur guten mechanischen Verbindung der Vergussmasse mit dem Chipträger ist die Verankerungskante in die Vergussmasse eingebettet. Dazu ist erfindungsgemäß vorgesehen, dass der die Verankerungskante bildende Flächenabschnitt abgekantet ist.

Die elektrische Verbindung des Halbleiterchips kann anstelle durch Bonddrähte durch andere Verbindungsmittel erfolgen.

Die Erfindung umfasst ferner eine elektronische Einrichtung, insbesondere eine Chipkarte, Gesundheitskarte, Bankkarte, Fahrkarte für den öffentlichen Verkehr, Hotelkarte, papierfolienartige Karte, wie Eintrittskarte, oder einen Ausweis oder Reisepass mit einem erfindungsgemäßen Modul.

Im Rahmen des erfindungsgemäßen Verfahrens zur Herstellung eines bandförmigen Substrates mit mehreren Chipträgereinheiten werden die Einheiten jeweils durch Ausbilden von Durchbrüchen strukturiert. Das Strukturieren kann beispielsweise durch Stanzen oder Schneiden erfolgen. Ein an den Durchbruch angrenzender Flächenabschnitt der jeweiligen Einheit wird zur Bildung der Verankerungskante abgekantet. Die Durchbrüche weisen abkantungsfreie Krümmungen und/oder abkantungsfreie Ausnehmungen zur Verringerung mechanischer Spannungen auf.

Im Stand der Technik wird für die Herstellung des bandförmigen Substrates üblicherweise eine Kupferlegierung verwendet. Die Erfindung zeigt überraschenderweise, dass die Verwendung einer Metallfolie aus reinem hartgewalzten austenitischen Edelstahl mit einer Dicke von 15 µm bis 35 µm zu einer ausreichenden Stabilität führt, insbesondere dann, wenn die Verankerungskante durch Abkanten des an den jeweiligen Durchbruch angrenzenden Flächenabschnitt der Folie erzeugt wird.

Die Erfindung wird nachfolgend mit weiteren Einzelheiten unter Bezug auf die beigefügten schematischen Zeichnungen anhand von Ausführungsbeispielen näher erläutert.

In diesen zeigen
- Fig. 1: ein bandförmiges Substrat mit mehreren Einheiten zur Herstellung von Chipträgern nach dem Stand der Technik;
- Fig. 2: einen Ausschnitt aus einem bandförmigen Substrat nach einem Ausführungsbeispiel der Erfindung mit erfindungsgemäß ausgebildeten Verankerungskanten;
- Fig. 3: einen Schnitt durch das Substrat gemäß Fig. 2 entlang der Linie A-A;
- Fig. 4: einen Schnitt durch das Substrat gemäß Fig. 2 entlang der Linie B-B;
- Fig. 5: eine Draufsicht auf ein Substrat nach einem erfindungsgemäßen Beispiel mit glatten Verankerungskanten ohne Mold-Kappe;
- Fig. 6: eine perspektivische Ansicht der Oberseite des Substrats gemäß Fig. 5;
- Fig. 7: eine perspektivische Ansicht des Substrats gemäß Fig. 5 mit Halbleiterchip und Mold-Kappe;
- Fig. 8: einen Ausschnitt des Substrats gemäß Fig. 6; und
- Fig. 9: eine Variante einer Verankerungskante.

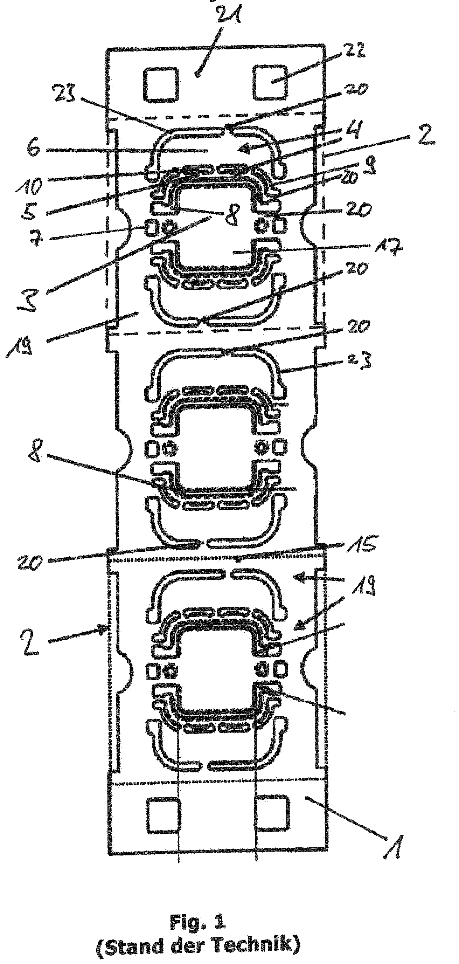

Der in Fig. 1 dargestellte Grundaufbau des bandförmigen Substrates kann auch im Rahmen der Erfindung verwirklicht werden. Die Erfindung unterscheidet sich von dem in Fig. 1 dargestellten Substrat u.a. durch die Ausbildung der Verankerungskanten, die in Fig. 1 nicht näher dargestellt sind.

Die Erfindung ist nicht auf den in Fig. 1 dargestellten Grundaufbau, insbesondere die Strukturierung des Substrates eingeschränkt. Von der Erfindung sind auch Substrate umfasst, die mit anderen Geometrien strukturiert sind. Beispielsweise können weitere Entlastungsschlitze zur Verringerung mechanischer Spannungen vorgesehen sein, die, wenn sie im Bereich der Moldmasse bzw. der Vergussmasse angeordnet sind, mit erfindungsgemäß ausgebildeten Verankerungskanten versehen sein können.

Das bandförmige Substrat gemäß Fig. 1 ist ein Vorprodukt, das zu einem Package oder elektronischen Modul weiterverarbeitet wird. Die in das Substrat eingebrachten Verankerungskanten sind auch in dem weiterverarbeiteten Modul bzw. im Endprodukt, beispielsweise einer Chipkarte oder allgemein in der elektronischen Einrichtung, vorhanden.

Im Einzelnen ist das bandförmige Substrat gemäß Fig. 1 wie folgt aufgebaut. Die nachfolgende Beschreibung wird explizit im Zusammenhang mit der Erfindung bzw. mit allen Ausführungsbeispielen der Anmeldung offenbart.

Das bandförmige Substrat ist aus einer flexiblen Folie 1 hergestellt. Die flexible Folie ist vorzugsweise eine Stahlfolie, insbesondere eine Folie aus hartgewalztem, austenitischen Edelstahl. Die Folie weist mehrere Einheiten 2 auf, die zur Herstellung von elektronischen Modulen in einem späteren Verfahrensschritt vereinzelt werden. Die Einheiten 2 sind jeweils identisch aufgebaut. Jede Einheit 2 weist eine Chipinsel 3 auf, auf der ein Halbleiterchip befestigbar ist.

Als Halbleiterchip kommen verschiedene Ausführungsformen in Frage. Diese können einen elektronischen Speicher, beliebige elektronische Schaltungen (integrierte Schaltungen - ICs) oder auch LEDs umfassen.

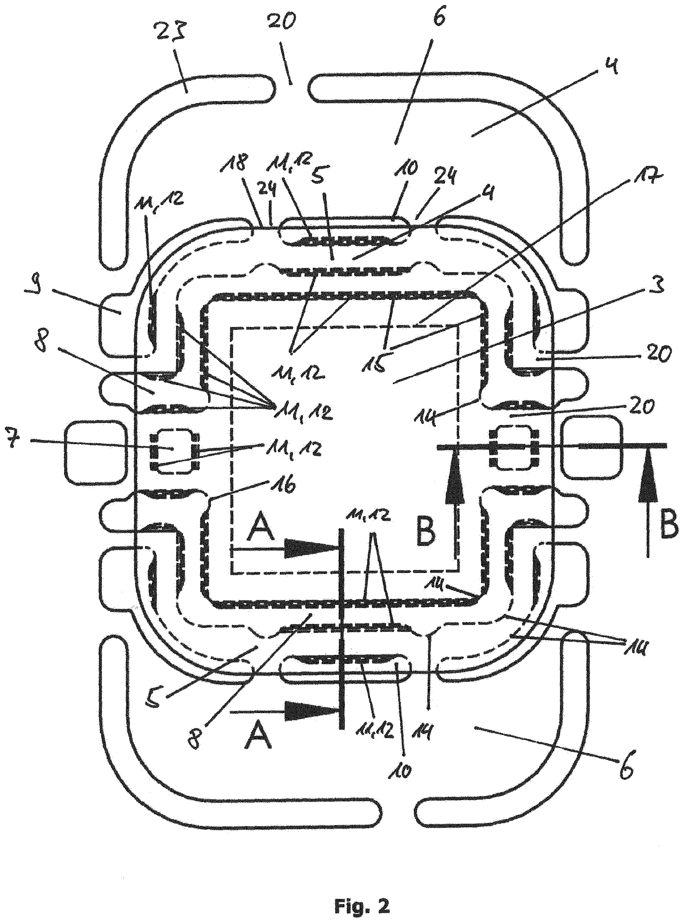

Im Rahmen der Erfindung wird das bandförmige Substrat sowohl ohne Halbleiterchips als auch mit Halbleiterchips beansprucht. In Fig. 1 ist, ebenso wie in Fig. 2, das Substrat im bestückten Zustand, d.h. mit Halbleiterchips 17, dargestellt.

Das Substrat umfasst mehr als die in Fig. 1 dargestellten Einheiten 2. Üblicherweise erstreckt sich das Substrat in Querrichtung zu den dargestellten drei Einheiten 2. Das Substrat kann beschichtet sein bzw. ist beschichtet.

Jede Einheit 2 umfasst Elektroden 4 zur elektrischen Verbindung des jeweiligen Halbleiterchips 17. Die Elektroden 4 umgeben die Chipinseln 3 jeweils auf beiden Seiten. Die Chipinseln 3 sind elektrisch neutral. Jede Elektrode 4 ist in zwei Teilbereiche unterteilt und zwar in ein Bond Pad 5 bzw. eine BondAnschlussfläche 5, die zur elektrischen Kontaktierung der Halbleiterchips mit Hilfe von Bonddrähten (nicht dargestellt) dient. Andere elektrische Verbindungen sind möglich. Der zweite Teilbereich der jeweiligen Elektrode 4 ist eine äußere Kontaktfläche, beispielsweise ein Antennen Pad 6, an der beispielsweise eine Antenne (nicht dargestellt) oder eine Spannungsversorgung (nicht dargestellt) angeschlossen werden kann.

Das bandförmige Substrat ist mit Durchbrüchen 7, 8, 9, 10 versehen, mit deren Hilfe die jeweilige Einheit 2 strukturiert ist und die vorstehend genannten Funktionsbereiche der Einheit 2 voneinander abgegrenzt sind.

Erste Durchbrüche 7 sind seitlich von der Chipinsel 3 ausgebildet. Die ersten Durchbrüche 7 sind im Wesentlichen viereckig, insbesondere quadratisch ausgebildet. Andere Geometrien sind möglich.

Die Einheit 2 umfasst zweite Durchbrüche 8, die die Chipinsel 3 begrenzen und im Wesentlichen deren Form und Größe bestimmen. Die zweiten Durchbrüche 8 sind spiegelsymmetrisch auf beiden Seiten der Chipinsel 3 angeordnet. Die zweiten Durchbrüche 8 sind im Wesentlichen U-förmig ausgebildet. Jeder zweite Durchbruch 8 weist einen quer zur Längsrichtung der Einheit 2 angeordneten Querschenkel auf, der die Breite der Chipinsel 3 bestimmt. Die beiden in Längsrichtung der Einheit 2 angeordneten Längsschenkel der Durchbrüche 8 sind kürzer als die Längsseite der Chipinsel 3, so dass die Enden der Längsschenkel der zweiten Durchbrüche 8 voneinander beabstandet sind.

Die ersten Durchbrüche 7 sind zwischen den zweiten Durchbrüchen 8 angeordnet.

Das Substrat gemäß Fig. 2 weist ferner dritte und vierte Durchbrüche 9, 10 auf, die das Bond Pad 5 vom Antennen Pad 6 trennen. Zwischen den dritten und vierten Durchbrüchen 9, 10 sind Verbindungsstege 24 ausgebildet, die die elektrische Verbindung des Bond Pads 5 und des Antennen Pads 6 herstellen.

Die dritten Durchbrüche 9 sind abschnittsweise gekrümmt und erstrecken sich im Bereich der Ecken der zweiten Durchbrüche 8.

Die vierten Durchbrüche 10 sind parallel zu dem Querschenkel des zweiten Durchbruchs 8 angeordnet. Anstelle des in Fig. 2 dargestellten einzigen vierten Durchbruchs 10 können auf der jeweiligen Seite der Chipinsel 3 jeweils zwei Durchbrüche 10 vorgesehen sein, wie beispielsweise in Fig. 1 dargestellt.

Die Einheit 2 gemäß Fig. 2 weist ferner Durchbrüche 23 auf, die außerhalb der Vergussmasse angeordnet sind und dementsprechend keine Verankerungskante aufweisen. Die Durchbrüche 23 ohne Verankerungskante grenzen die Antennen Pads 6 von den in Fig. 1 dargestellten Restbereichen 19 der Folie ab. Zwischen den Durchbrüchen 23 ist jeweils ein Steg 20 ausgebildet, der vor der Funktionsprüfung entfernt wird und der Handhabung des Substrates bei der Verarbeitung dient. Dasselbe gilt für die Stege 20 zwischen den zweiten und dritten Durchbrüchen 8, 9.

Die Restbereiche 19 jeder Einheit umgeben die Elektroden 4 sowie die Chipinsel 3 und sorgen für den mechanischen Zusammenhalt des Substrates bei der Verarbeitung. Die Elektroden 4 und die Chipinseln 3 bilden einen Teil der aus dem Substrat hergestellten elektrischen Module. Die Restbereiche 19 sowie der Förderstreifen 21 werden bei der Herstellung entfernt. Das Herstellungsverfahren ist im Detail in DE 20 2012 100 694 U1 in den Absätzen [0078] bis [0084] beschrieben, auf die an dieser Stelle explizit Bezug genommen wird.

Zum Schutz und zur Fixierung des Halbleiterchips 17 wird dieser in eine Vergussmasse 18 eingebettet. Die Vergussmasse 18 umgibt den Halbleiterchip 17 und die Bonddrähte und erstreckt sich zumindest teilweise auf die Elektrode 4, insbesondere auf die Bondanschlussfläche bzw. das Bond Pad 5. Für eine sichere Funktionsweise der Module bzw. der daraus hergestellten Bauelemente kommt es darauf an, dass die Vergussmasse 18 bzw. die daraus gebildete Mold-Kappe fest mit dem bandförmigen Substrat bzw. nach Vereinzelung der jeweiligen Einheiten 2 mit dem Chipträger verbunden ist.

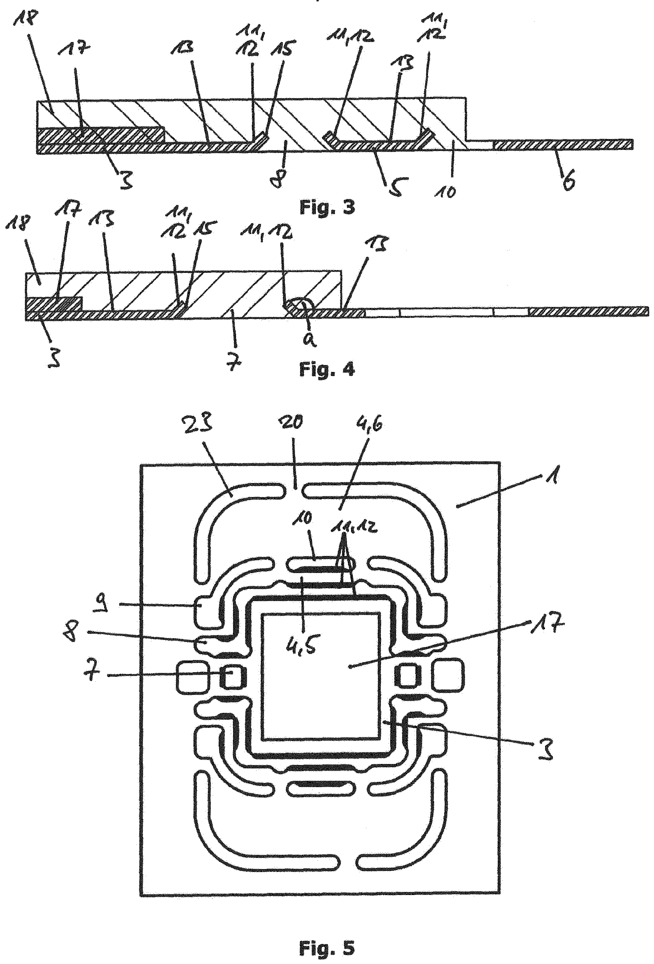

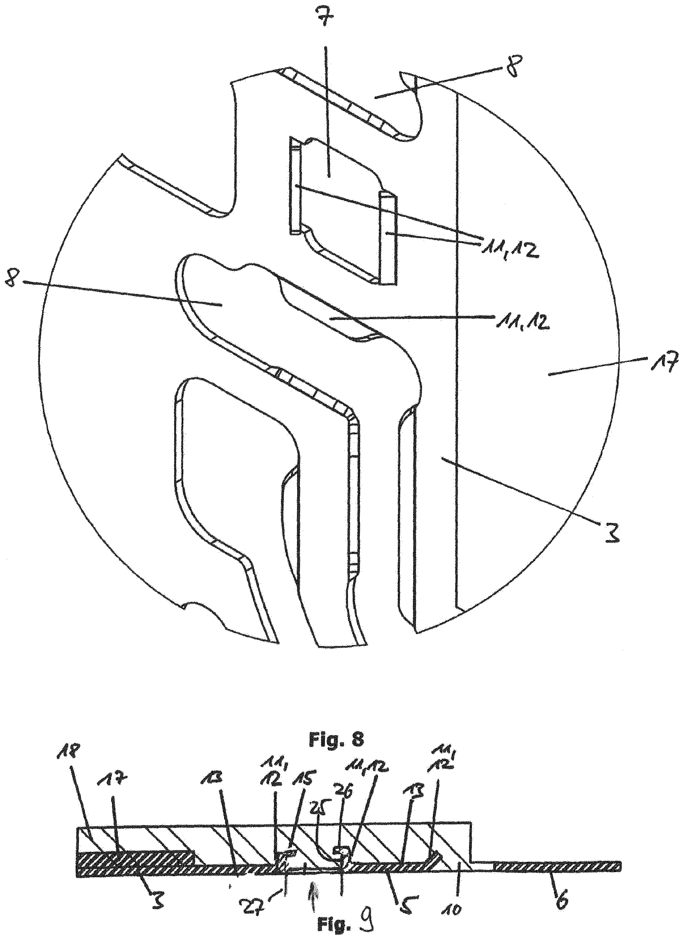

Dazu weisen die Durchbrüche 7, 8, 9, 10 Verankerungskanten 11 auf, die mit der Vergussmasse 18 bei der Einkapselung des Halbleiterchips zusammenwirken. Der Aufbau der Verankerungskanten 11 ist in den Fig. 3, 4 und 8 dargestellt. Eine Variante mit einer profilierten Verankerungskante ist in Fig. 9 gezeigt. Wie in den Fig. 3, 4 und 9 gut zu sehen, werden die Verankerungskanten 11 durch Abkanten der an den jeweiligen Durchbruch 7, 8, 9, 10 angrenzenden Flächenabschnitte 12 gebildet.

Unter Abkanten wird ein Umformen der Folie verstanden, bei der der Randbereich der den jeweiligen Durchbruch 7, 8, 9, 10 begrenzenden Folie umgebogen wird. Konkret wird der angrenzende Flächenabschnitt 12 nach oben, d.h. so umgebogen bzw. abgekantet, dass die Verankerungskante 11 über die Seite der Folie 1 vorsteht, auf der die Chipinsel 3 angeordnet ist. Die Verankerungskante 11 ragt etwas über die Oberfläche der umgebenden Folie 1 hinaus. Diese Anordnung ist in den Fig. 3, 4 und 9 gut zu erkennen.

Der Abkantwinkel zwischen dem abgekanteten Flächenabschnitt 12 und der weiteren Fläche 13 der Folie 1, die den abgekanteten Flächenabschnitt 12 umgibt, beträgt bei den Fig. 3, 4 im Fall der nicht profilierten, d.h. flachen Verankerungskante ca. 45°. Der Abkantwinkel kann sich in einem Bereich von 30° bis 60°, insbesondere von 40° bis 50° bewegen. In Fig. 4 ist der Abkantwinkel mit dem Bezugszeichen a bezeichnet. Die weitere Fläche 13 der Folie 1 erstreckt sich in den Darstellungen gemäß Fig. 3, 4 in der Horizontalen. Auf die weitere Fläche 13 der Folie 1 bezogen ist der abgekantete Flächenabschnitt 12 nach oben geneigt bzw. allgemein geneigt.

Der maximale Abkantwinkel einer profilierten Verankerungskante kann ca. 90° betragen, wie in Fig. 9 zu sehen. Auch hier ist ein Winkelbereich möglich, wobei die Untergrenze bspw. 40° oder 45° oder größer betragen kann.

Die Breite des abgekanteten Flächenabschnitts 12 ist so bemessen, dass ein ausreichender Verankerungseffekt erreicht wird, wenn der Halbleiterchip 17 mit der Vergussmasse 18 eingekapselt ist. Wie in den Fig. 3, 4 zu erkennen, kann die Breite des abgekanteten Flächenabschnitts 12 in etwa so bemessen sein, dass die Oberkante des abgekanteten Flächenabschnitts 12 in etwa auf der Höhe der Oberkante des Halbleiterchips 17 oder etwas darunter angeordnet ist.

Wie in den Fig. 2 und 5 gut zu erkennen, sind die abgekanteten Flächenabschnitte 12 gerade, d.h. sie sind an geraden Seiten der Durchbrüche ausgebildet. Die abgekanteten Flächenabschnitte 12 erstrecken sich entlang der geraden Seiten der Durchbrüche. Allgemein sind nur gerade Seiten der Durchbrüche abgekantet.

Flächenabschnitte, die an gekrümmte Bereiche der Durchbrüche angrenzen, fluchten mit der weiteren Fläche 13 der Folie 1. Es handelt sich also um abkantungsfreie Krümmungen 14 der Durchbrüche. Mit anderen Worten sind die Flächenabschnitte 14 an den gekrümmten Bereichen, insbesondere an allen gekrümmten Bereichen, nicht abgekantet bzw. umgebogen.
Darüber hinaus sind, wie in Fig. 2 und 5 zu sehen, an den Ecken der zweiten Durchbrüche 8 abkantungsfreie Ausnehmungen 16 ausgebildet, die mechanische Spannungen im Bereich der Chipinsel 3 abbauen. Die Ausnehmungen 16 bilden Ausrundungen, die sich jeweils an der Innenseite der sich in Längsrichtung der Einheit 2 erstreckenden Längsschenkel der zweiten Durchbrüche 8 befinden. Bei dem in den Fig. 2 und 5 dargestellten Ausführungsbeispiel sind an vier Ecken der zweiten Durchbrüche 8 entsprechende abkantungsfreie Ausnehmungen 16 vorgesehen.

Wie in den Fig. 2 bis 4 gut zu sehen, sind die Verankerungskanten 11 nur im Bereich der Vergussmasse 18 ausgebildet.

Zur Stabilisierung der Chipinsel 3 sind an den Innenseiten 15 der zweiten Durchbrüche 8 abgekantete Flächenabschnitte 12 ausgebildet. Durch diese Profilierung der Folie wird eine Stabilisierung der Chipinsel 3 bewirkt. Die gekrümmten Bereiche der Innenseiten 15 der zweiten Durchbrüche 8 sind abkantungsfrei.

Wie in den Fig. 2 und 5 gut zu sehen, sind abgekantete Flächenabschnitte 12 bzw. allgemein Verankerungskanten 11 an der Innenseite des vierten Durchbruchs 10 vorgesehen. Die Verankerungskanten 11 sind an den geraden Bereichen der Innenseite der dritten Durchbrüche 9 ausgebildet. Die zweiten Durchbrüche 8 weisen sowohl an den geraden Bereichen der Innenseite 15 als auch an den geraden Bereichen der Außenseite jeweils Verankerungskanten 11 bzw. abgekantete Flächenabschnitte 12 auf. Dasselbe gilt für den ersten Durchbruch 7.

Im Unterschied zu der Darstellung in Fig. 2, bei der der Halbleiterchip 17 eingekapselt ist, ist der Halbleiterchip 17 bei der Darstellung gemäß Fig. 5 freiliegend angeordnet. In Fig. 5 ist die Lage der Verankerungskanten gut zu sehen.

Ein weiterer Unterschied zwischen den Beispielen gemäß Fig. 2 und 5 besteht darin, dass in Fig. 2 die Verankerungskanten 11 kammartig profiliert sind. Die kammartige Profilierung gemäß Fig. 2 erstreckt sich in Längsrichtung der Verankerungskante 11. Die abgekanteten Flächenabschnitte 12 weisen eine profilierte Außenkante auf. Die profilierte Außenkante ist durch eine Vielzahl von gleichförmigen Einkerbungen oder Freimachungen gebildet, die entlang der Außenkante angeordnet sind. Daraus ergibt sich das kammartige Profil. Die dargestellten Einkerbungen sind im Wesentlichen rechteckig. Andere Geometrien sind möglich.

Bei dem Beispiel gemäß Fig. 5 sind die Verankerungskanten glatt. Sie weisen eine kontinuierliche, gerade Außenkante auf. Die Außenkante ist nicht unterbrochen, wie in Fig. 2. Eine Kombination der Beispiele gemäß Fig. 2 und 5 ist möglich.

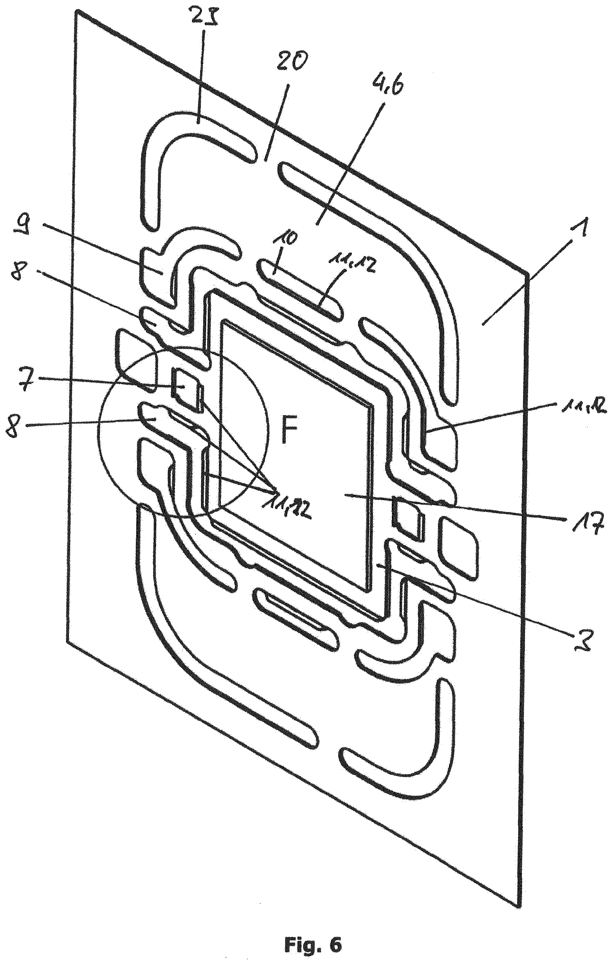

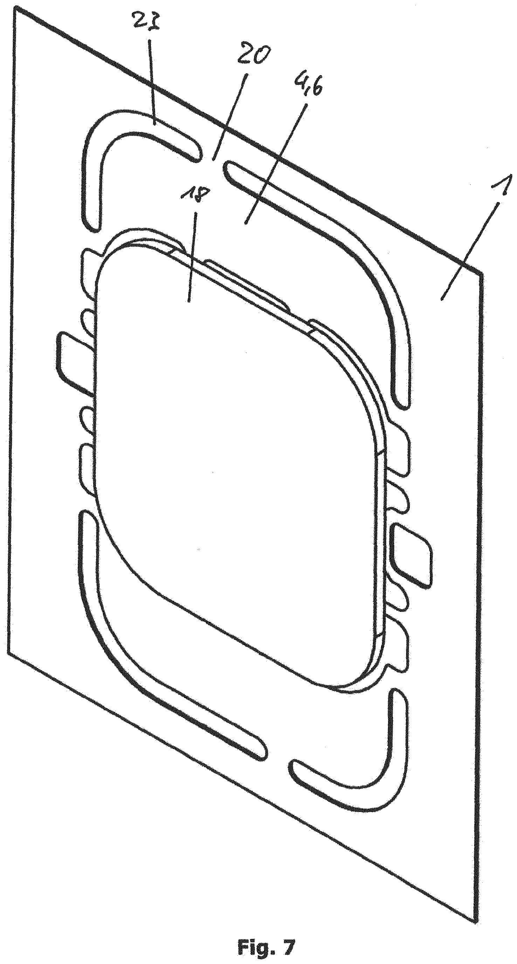

Fig. 6 entspricht dem Zwischenzustand gemäß Fig. 5. Aufgrund der perspektivischen Darstellung gemäß Fig. 6 ist die Anordnung der abgekanteten Flächenabschnitte 12 gut zu sehen. In Fig. 7 ist der Halbleiterchip 17 gemäß Fig. 6 in die Vergussmasse 18 eingegossen, die eine Mold-Kappe bildet.

Fig. 8 zeigt einen Detailausschnitt gemäß Fig. 6. Darin ist die Form der Verankerungskanten gut zu erkennen. Die Verankerungskanten können, wie im Zusammenhang mit dem ersten Durchbruch 7 zu sehen, flache Stirnflächen aufweisen. Anderen Formen der Verankerungskanten 11 sind möglich, wie im Zusammenhang mit dem zweiten Durchbruch 8 dargestellt. Darin ist zu sehen, dass die Verankerungskante 11 eine gekrümmte Stirnfläche aufweist, die kontinuierlich in die Innenseite 15 des Durchbruchs 8 übergeht.

Fig. 9 zeigt eine Variante der Verankerungskante 11. Die Verankerungskante 11 ist quer zur Längserstreckung der Verankerungskante 11 profiliert. Der abgekantete Flächenabschnitt 12 weist einen ersten Schenkel 25 auf, der sich senkrecht zu der weiteren, angrenzenden Fläche 13 der Folie erstreckt, die nicht umgebogen ist. Der erste Schenkel 25 geht in einen zweiten Schenkel 26 über, der sich senkrecht zum ersten Schenkel 26 erstreckt und eine Außenkante des abgekanteten Flächenabschnittes 12 bildet. Daraus ergibt sich ein L-förmiges Profil der Verankerungskante 11. Wenn man die weitere Fläche 13 der Folie hinzunimmt, ergibt sich insgesamt ein Z-förmiges Profil. Das Profil erstreckt sich entlang der Seite des jeweiligen Durchbruches. Das Profil erlaubt eine sichere Verankerung der Vergussmasse 18.

Andere Profile sind möglich. Verschiedene Profile können kombiniert werden.

Zur Herstellung wird ein Umformwerkzeug 27 verwendet, wie in Fig. 9 dargestellt. Bei dem Vorgang wird das Material tiefgezogen (downsetten). Die Materialstärke verringert sich.

Die im Zusammenhang mit den Ausführungsbeispielen verwendete Folie ist eine Metallfolie aus einem hartgewalzten, austenitischen Edelstahl. Die Dicke der Folie beträgt 15 µm bis 35 µ, konkret ca. 20 µm. Dadurch kann die Gesamtdicke des Packages bzw. des elektrischen Moduls auf 200 µm verringert werden. Die sichere Fixierung der Vergussmasse 18 erfolgt durch die nach oben abgekanteten Flächenabschnitte 12.

Die Herstellung eines elektronischen Moduls unter Verwendung des Trägersubstrats gemäß den Fig. 2 bis 8 erfolgt wie folgt: Zunächst wird jeweils ein Halbleiterchip 17 auf die Oberseite der jeweiligen Chipinsel 3 jeder Einheit 2 aufgesetzt und dort befestigt. Der Halbleiterchip 17 kann beispielsweise aufgeklebt werden. Anschließend wird der Halbleiterchip 17 mit Bonddrähten (nicht dargestellt) mit den Bond Pads 5 verbunden. Danach werden der Halbleiterchip 17 und die Bonddrähte fixiert, indem eine Moldmasse bzw. Vergussmasse 18, beispielsweise ein Epoxidharz, aufgetragen wird. Dabei läuft die Vergussmasse unter die abgekanteten Flächenabschnitte 12, wodurch diese eingebettet werden. Nach dem Aushärten der Vergussmasse 18 ist diese mit dem Substrat fest verankert.

Der so entstandene Aufbau ist in den Fig. 2 bis 4 und 7 dargestellt.

Anschließend wird der Aufbau elektronisch freigestanzt. Dabei werden die Stege 20, die die Elektroden 4 mit den Restbereichen 19 mechanisch und elektrisch leitend verbinden, entfernt. Dies betrifft die Stege 20 zwischen den Durchbrüchen 23 sowie die Stege 20 zwischen den zweiten und dritten Durchbrüchen 8, 9. Die Verbindungsstege 24 zwischen den dritten und vierten Durchbrüchen 9, 10 bleiben bestehen.

Die Stege 20 zwischen den ersten und zweiten Durchbrüchen 7, 8 bewirken, dass die Struktur des Substrates ausreichend stabil zusammenhängt, so dass dieses weiterverarbeitet werden kann. Anschließend erfolgt die Funktionsprüfung, um fehlerhafte Module aussortieren zu können.

Danach werden die Module aus der Folie 1 herausgetrennt, indem die Stege 20 zwischen den ersten und zweiten Durchbrüchen 7, 8 entfernt werden. Die so hergestellten elektronischen Module können anschließend verbaut werden, indem beispielsweise Drähte oder Leiterbahnen als Antennen oder elektrische Stromleitungen mit den äußeren Anschlussflächen bzw. Antennen Pads 6 verbunden werden.

### Bezugszeichenliste

- 1: Folie (Metallfolie)
- 2: Einheit
- 3: Chipinsel
- 4: Elektroden
- 5: Bond Pad
- 6: Antennen Pad
- 7: erste Durchbrüche
- 8: zweite Durchbrüche
- 9: dritte Durchbrüche
- 10: vierte Durchbrüche
- 11: Verankerungskante
- 12: abgekanteter (erster) Flächenabschnitt
- 13: weitere Fläche der Folie
- 14: (zweiter) Flächenabschnitt
- 15: Innenseiten der Durchbrüche
- 16: abkantungsfreie Ausnehmungen
- 17: Halbleiterchip
- 18: Vergussmasse
- 19: Restbereiche
- 20: Stege
- 21: Förderstreifen
- 22: Förderöffnung
- 23: Durchbrüche ohne Verankerungskanten
- 24: Verbindungsstege
- 25: 25 erster Schenkel
- 26: zweiter Schenkel
- 27: Umformwerkzeug

## Patentansprüche

1. Bandförmiges Substrat aus einer Folie (1) mit mehreren Einheiten (2) zur Herstellung von Chipträgern, wobei jeweils eine Einheit eine Chipinsel (3) zur Befestigung eines Halbleiterchips, Elektroden (4) zur elektrischen Verbindung des Halbleiterchips und Durchbrüche (7, 8, 9, 10) zur Strukturierung der Einheit (2) aufweist, wobei wenigstens ein Durchbruch (7, 8, 9, 10) eine Verankerungskante (11) für eine Vergussmasse zur Einkapselung des Halbleiterchips bildet, wobeiein an den Durchbruch (7, 8, 9, 10) angrenzender Flächenabschnitt (12) der Folie (1) zur Bildung der Verankerungskante (11) abgekantet ist, wobei die Verankerungskante (11) über die Seite der Folie (1) vorsteht, auf der die Chipinsel (3) angeordnet ist, wobei die Durchbrüche (8) abkantungsfreie Krümmungen (14) und/oder abkantungsfreie Ausnehmungen (16) zur Verringerung mechanischer Spannungen aufweisen,
**durch gekennzeichnet**, dass
die Folie (1) aus einem hartgewalzten austenitischen Edelstahl gebildet ist und eine Dicke von 15 µm bis 35 µm aufweist.

2. Substrat nach Anspruch 1,
**dadurch gekennzeichnet, dass**
ein Abkantwinkel zwischen dem abgekanteten Flächenabschnitt (12) und der weiteren Fläche (13) der Folie (1) von 30° bis 60°, insbesondere von 40° bis 50° beträgt.

3. Substrat nach einem der vorhergehenden Ansprüche,
**dadurch gekennzeichnet, dass**
wenigstens ein abgekanteter Flächenabschnitt (12) gerade ist.

4. Substrat nach einem der vorhergehenden Ansprüche,
**dadurch gekennzeichnet, dass**
wenigstens ein abgekanteter Flächenabschnitt (12) ein kammartiges Profil zur Verringerung mechanischer Spannungen aufweist und/oder wenigstens ein abgekanteter Flächenabschnitt (12) eine glatte Außenkante aufweist.

5. Substrat nach einem der vorhergehenden Ansprüche,
**dadurch gekennzeichnet, dass**
wenigstens Durchbrüche (8), die an die Chipinsel (3) angrenzen, insbesondere deren Innenseiten (15), Verankerungskanten (11) aufweisen.

6. Elektronisches Modul mit einem Chipträger, der eine Chipinsel (3) und einen darauf befestigten Halbleiterchip (17), Elektroden (4) zur elektrischen Verbindung des Halbleiterchips (17), insbesondere durch Bonddrähte, und Durchbrüche (7, 8, 9, 10) zur Strukturierung des Chipträgers aufweist, wobei wenigstens ein Durchbruch (7, 8, 9, 10) eine Verankerungskante (11) für eine Vergussmasse (18) bildet, die den Halbleiterchip (17) einkapselt, wobei
ein an den Durchbruch (7, 8, 9, 10) angrenzender Flächenabschnitt (12) des Chipträgers zur Bildung der Verankerungskante (11) abgekantet ist, wobei die Verankerungskante (11) über die Seite des Chipträgers vorsteht, auf der die Chipinsel (3) angeordnet ist, und in die Vergussmasse (18) eingebettet ist, wobei die Durchbrüche (8) abkantungsfreie Krümmungen (14) und/oder abkantungsfreie Ausnehmungen (16) zur Verringerung mechanischer Spannungen aufweisen,
**durch gekennzeichnet**, dass
die Dicke des Chipträgers 15 µm bis 35 µm aufweist und der Chipträger aus einem hartgewalzten austenitischen Edelstahl gebildet ist.

7. Elektronische Einrichtung, insbesondere Chipkarte, Gesundheitskarte, Bankkarte, Fahrkarte für den öffentlichen Verkehr, Hotelkarte, Ausweis, Reisepass, papierfolienartige Karte, wie Eintrittskarte, mit einem Modul nach Anspruch 6.

8. Verfahren zur Herstellung eines bandförmigen Substrates mit mehreren Chipträger-Einheiten (2) nach einem der Ansprüche 1 bis 5 für die Weiterverarbeitung zur Fertigung von elektrischen Modulen, bei dem die Einheiten (2) jeweils durch Ausbilden von Durchbrüchen (7, 8, 9, 10), insbesondere durch Stanzen, strukturiert werden, wobei ein an den Durchbruch (7, 8, 9, 10) angrenzender Flächenabschnitt (12) der jeweiligen Einheit (2) zur Bildung einer Verankerungskante (11) für eine Vergussmasse abgekantet wird, wobei die Durchbrüche (8) abkantungsfreie Krümmungen (14) und/oder abkantungsfreie Ausnehmungen (16) zur Verringerung mechanischer Spannungen aufweisen, **dadurch gekennzeichnet, dass** die Dicke des Chipträgers 15 µm bis 35 µm aufweist und der Chipträger aus einem hartgewalzten austenitischen Edelstahl gebildet ist.

## Claims

1. Strip-shaped substrate of a foil (1) with several units (2) for producing chip carriers wherein each unit comprises a chip island (3) for fastening a semiconductor chip, electrodes (4) for the electrical connection of the semiconductor chip and apertures (7, 8, 9, 10) for structuring the unit (2), wherein at least one aperture (7, 8, 9, 10) forms an anchoring edge (11) for a sealing compound for encapsulating the semiconductor chip, wherein a surface section (12) of the foil (1) adjoining the aperture (7, 8, 9, 10) is bevelled to form the anchoring edge (11), wherein the anchoring edge (11) protrudes over the side of the foil (1) on which the chip island (3) is arranged, wherein the apertures (8) have unbevelled curves (14) and/or unbevelled recesses (16) to reduce mechanical stresses
**characterised in that**
the foil (1) is made of a hard-rolled austenitic stainless steel and has a thickness of 15 µm to 35 µm.

2. Substrate according to claim 1
**characterised in that**
a bevel angle between the bevelled surface section (12) and the further surface (13) of the film (1) is 30° to 60°, more particularly 40° to 50°.

3. Substrate according to any one of the preceding claims
**characterised in that**
at least one bevelled surface section (12) is straight.

4. Substrate according to any one of the preceding claims
**characterised in that**
at least one bevelled section (12) has a comb-like profile for reducing mechanical stresses and/or at least one bevelled section (12) has a smooth outer edge.

5. Substrate according any one of the preceding claims
**characterised in that**
at least apertures (8) adjoining the chip island (3) in particular on their inner sides (15) have anchoring edges (11).

6. Electronic module with a chip carrier which comprises a chip island (3) and, fastened thereon, a semiconductor chip (17), electrodes (4) for the electrical connection of the semiconductor chip (17), in particular by way of bond wires, and apertures (7, 8, 9, 10) for structuring the chip carrier, wherein at least one aperture (7, 8, 9, 10) forms an anchoring edge (11) for a sealing compound (18) which encapsulates the semiconductor chip (17), wherein
a surface section (12) of the chip carrier adjoining the aperture (7, 8. 9, 10) is bevelled to form the anchoring edge (11), wherein the anchoring edge (11) protrudes beyond the side of the chip carrier on which the chip island (3) is arranged, and is embedded in the sealing compound (18), wherein the aperture (8) have unbevelled curves (14) and/or unbevelled recesses (16) for reducing mechanical stresses,
**characterised in that**
the thickness of the chip carrier is 15 µm to 35 µm and the chip carrier is made of hard-rolled austenitic stainless steel.

7. Electronic device, in particular a chip card, health card, bank card, ticket for public transport, hotel card, identity card, passport, paper film-like card, such as an entrance ticket, with a module according to claim 6.

8. Method of producing a strip-like substrate with several chip carrier units (2) according to any one of claims 1 to 5 for further processing in order to produce electrical modules in which the units (2) are each structured through the formation of apertures (7, 8, 9, 10), in particular through punching, wherein a surface section (12) of the respective element (2) adjoining the aperture (7, 8, 9, 10) is bevelled to form an anchoring edge (11) for a sealing compound, wherein the apertures (8) comprise unbevelled curves (14) and/or unbevelled recesses (16) in order to reduce mechanical stresses, **characterised in that** the thickness of the chip carrier is 15 µm to 35 µm and the chip carrier is made of a hard-rolled austenitic stainless steel.

## Revendications

1. Substrat en forme de bande à partir d'une feuille (1) avec plusieurs unités (2) servant à produire des supports de puce, sachant qu'une unité comporte respectivement un îlot de puce (3) pour la fixation d'une puce semi-conductrice, des électrodes (4) pour la liaison électrique de la puce semi-conductrice et des percées (7, 8, 9, 10) pour structurer l'unité (2), sachant qu'au moins une percée (7, 8, 9, 10) forme un bord d'ancrage (11) pour une masse de remplissage destinée à encapsuler la puce semi-conductrice, sachant qu'une section de surface (12) de la feuille (1), adjacente à la percée (7, 8, 9, 10) est repliée pour former le bord d'ancrage (11), sachant que le bord d'ancrage (11) fait saillie sur le côté de la feuille (1), sur lequel l'îlot de puce (3) est disposé, sachant que les percées (8) comportent des courbures (14) sans repli et/ou des évidements (16) sans repli pour réduire les contraintes mécaniques,
**caractérisé en ce que**
la feuille (1) est formée d'un acier spécial austénitique laminé dur et comporte une épaisseur de 15 µm à 35 µm.

2. Substrat selon la revendication 1,
**caractérisé en ce qu'**
un angle de pliage entre la section de surface (12) repliée et l'autre surface (13) de la feuille (1) est de 30° à 60°, notamment de 40° à 50°.

3. Substrat selon l'une quelconque des revendications précédentes,
**caractérisé en ce qu'**
au moins une section de surface (12) repliée est est droite.

4. Substrat selon l'une quelconque des revendications précédentes,
**caractérisé en ce qu'**
une section de surface (12) repliée comporte un profil en forme de peigne pour réduire les contraintes mécaniques et/ou au moins une section de surface (12) repliée comporte un bord extérieur lisse.

5. Substrat selon l'une quelconque des revendications précédentes,
**caractérisé en ce qu'**
au moins les percées (8) qui sont adjacentes à l'îlot de puce (3), comportent notamment des bords d'ancrage (11) de leurs côtés intérieurs (15).

6. Module électronique avec un support de puce, qui comporte un îlot de puce (3) et une puce semi-conductrice (17) fixée dessus, des électrodes (4) pour la liaison électrique de la puce semi-conductrice (17), notamment par des fils de connexion et des percées (7, 8, 9, 10) pour la structuration du support de puce, sachant qu'au moins une percée (7, 8, 9, 10) forme un bord d'ancrage (11) pour une masse de remplissage (18) qui encapsule la puce semi-conductrice (17),
sachant qu'une section de surface (12) du support de puce adjacente à la percée (7, 8, 9, 10) est repliée pour former le bord d'ancrage (11), sachant que le bord d'ancrage (11) fait saillie sur le côté du support de puce sur lequel l'îlot de puce (3) est disposé et est intégré dans la masse de remplissage (18), sachant que les percées (8) comportent des courbures sans repli (14) et/ou des évidements sans repli (16) pour réduire les contraintes mécaniques,
**caractérisé en ce que**
l'épaisseur du support de puce comporte 15 µm à 35 µm et le support de puce est formé d'un acier spécial austénitique laminé dur.

7. Dispositif électronique, notamment carte à puce, carte de santé, carte bancaire, billet pour les transports publics, carte d'hôtel, carte d'identité, passeport, carte de type feuille de papier, comme billet d'entrée avec un module selon la revendication 6.

8. Procédé servant à produire un substrat en forme de bande avec plusieurs unités de support de puce (2) selon l'une quelconque des revendications 1 à 5 pour le traitement ultérieur destiné à la fabrication de modules électriques, pour lequel les unités (2) sont respectivement structurées par formation de percées (7, 8, 9, 10), notamment par estampage, sachant qu'une section de surface (12) adjacente à la percée (7, 8, 9, 10) de l'unité respective (2) est repliée pour former un bord d'ancrage (11) pour une masse de remplissage, sachant que les percées (8) comportent des courbures (14) sans repli et/ou des évidements sans repli (16) pour réduire les contraintes mécaniques, **caractérisé en ce que** l'épaisseur du support de puce comporte 15 µm à 35 µm et le support de puce est formé d'un acier spécial austénitique laminé dur.
